# EUROPEAN PATENT APPLICATION

(11) **EP 4 687 375 A1**
(43) Date of publication of application: **04.02.2026**
(21) Application number: 24191968.7
(22) Date of filing: 31.07.2024
(51) Int. Cl.: H05K 7/14

(54) **POWER ELECTRONIC COMPONENT AND SYSTEM**

(71) Applicant: Hitachi Energy Ltd, 8050 Zürich (CH)
(72) Inventor: Lutz, Pascal, 5432 Neuenhof (CH); Heinig, Stefanie, 4053 Basel (CH); Wu, Dan, 8700 Küsnacht (CH); Schwarzmaier, Thomas, 5430 Wettingen (CH); Maibach, Philippe, 5037 Muhen (CH)
(74) Representative: Epping - Hermann - Fischer

(57) **Abstract**

A power electronic component (1) is specified, comprising
- a housing (2) having a recess (3),
- a flexible cover (4) covering the recess (3),
- at least one power semiconductor module (7),
- a heat sink (8), wherein
- the at least one power semiconductor module (7) and the heat sink (8) are arranged inside the housing (2), and
- the flexible cover (4) has a folded part (6) for providing flexibility and a cover part (5) for covering the recess (3), the flexible cover (4) being configured to be expanded.

Furthermore, a system (1) is specified.

## Description

The present disclosure relates to a power electronic component and a system.

Typically, bond-wires connect terminal leads to semiconductor chips. In the presence of comparatively large short-circuit currents, the bond-wires vaporize, leading to severe arcing inside a typical package of the semiconductor chip as well as to an explosion.

An objective of the disclosure is to provide a power electronic component which has improved protection. A further embodiment relates to a system comprising such a power electronic component.

This is achieved by the subject-matter of the independent claims. Further embodiments are evident from the dependent claims and the following description.

A power electronic component is described. The term "power" here and in the following, for example, refers to power semiconductor chips particularly comprised by the power electronic component adapted for processing voltages and currents of more than 100 V and/or more than 10 A, exemplary voltages up to 10 kV and electrical currents up to 10 kA.

According to an embodiment, the power electronic component comprises a housing having a recess. The housing exemplarily defines a cavity. The housing is exemplarily configured to house elements of the power electronic component. In particular, at least some or all elements of the power electronic components are arranged within the cavity. For example, the housing is configured to provide a structural support for at least some of the elements. In particular, at least some of the elements are connected to the housing in a mechanically fixed manner.

The housing comprises a housing wall, for example. In particular, the recess completely extends through the housing wall. The recess provides, for example, a through hole to the cavity.

The housing comprises, for example, a metal material, such as steel, aluminium and/or copper, a composite material and/or a plastics material.

According to the embodiment, the power electronic component comprises a flexible cover covering the recess. For example, the flexible cover completely covers the recess. Exemplarily, the housing and the flexible cover delimit the cavity, particularly three-dimensionally. In particular, the housing and the flexible cover completely surround the cavity, and thus at least some or all of the elements of the power electronic component. In particular, the flexible cover is configured to prevent ingress of contaminants from the environment of the power electronic component.

According to the embodiment, the power electronic component comprises at least one power semiconductor module. The power semiconductor module comprises, for example, at least one power semiconductor chip. Exemplarily, the power semiconductor chip is connected to a wiring, e.g. comprising at least one bond wire.

The power semiconductor chip comprises, for example, a semiconductor material such as at least one of silicon (Si), silicon carbide (SiC), and gallium nitride (GaN). The power semiconductor chip is, for example, a power diode and/or a power metal insulating semiconductor field-effect transistor, power MISFET for short. The term MISFET shall also comprise MOSFETs, which have an oxide as insulating material at a gate. The power semiconductor chip may also be an insulated-gate bipolar transistor, IGBT.

The power semiconductor chip exemplarily comprises, for example, a carrier, on which the power semiconductor chip is arranged. Exemplarily, the carrier comprises a printed circuit board and/or a lead frame comprising a plurality of signal lines. Exemplarily, the wiring connects the printed circuit board and/or the lead frame with the power semiconductor chip. In particular, the carrier comprises an electrically insulating substrate, including an isolating sheet comprising a ceramic or resin.

According to the embodiment, the power electronic component comprises a heat sink. The power semiconductor module is exemplarily arranged on the heat sink. In particular, the carrier is arranged on the heat sink. The heat sink comprises, for example, fins and/or other structures configured to increase a surface area and particularly to increase cooling efficiency. The heat sink is exemplarily configured to absorb and dissipate heat from the power semiconductor chip.

If the power electronic component comprises more than one power semiconductor module, the power semiconductor modules are arranged on the heat sink. Particularly, the heat sink is a common heat sink for the power semiconductor modules.

According to the embodiment of the power electronic component, the at least one power semiconductor module and the heat sink are arranged inside the housing. In particular, the power semiconductor module and the heat sink are the elements of the power electronic component. The power semiconductor module and the heat sink are particularly arranged within the cavity.

For example, the heat sink is connected to the housing in a mechanically fixed manner and the power semiconductor module is arranged on the heat sink.

According to the embodiment of the power electronic component, the flexible cover has a folded part for providing flexibility and a cover part for covering the recess. The flexible cover is configured to be expanded. Exemplarily, the cover part is completely overlapping or partially overlapping with the recess in plan view on the cover part. If the cover part completely overlaps with the recess in plan view, the folded part partially does not overlap with the recess in plan view. If the cover part partially overlaps with the recess in plan view, the folded part partially overlaps with the recess in plan view.

A material of the flexible cover is, for example, not folded in the cover part. The recess extends along a main extension plane. A main extension plane of the cover part substantially extends, for example, parallel to the main extension plane of the recess. "Substantially" means here that the main extension plane of the recess and the main extension plane of the cover part enclose an angle of at most 5°, particularly at most 1°.

A material of the flexible cover is, for example, folded in the folded part. Exemplarily, parts of the folded part lie one on top of the other. The folded part is configured to be expanded such that the flexible cover expands in space. Exemplarily, a first cavity encloses a first volume, wherein the first cavity corresponds to the cavity as described herein above, which is defined by the housing and the flexible cover which is not expanded. For example, a second cavity encloses a second volume, wherein the second cavity is defined by the housing and the flexible cover which is expanded. In particular, the second volume is bigger than the first volume, exemplarily by at least 200 or at least 500.

During a failure event, a wiring and/or parts of the power semiconductor chip of the power semiconductor module can vaporize. In particular, the failure event exemplarily leads to an explosion comprising hot plasma and debris resulting from the vaporization. The failure event is, for example, characteristic of a short circuit event, e.g. of an electronic element of the power semiconductor module. In particular if the hot plasma and/or the debris are not contained, the hot plasma can cause catastrophic damage.

In summary, the power electronic component advantageously uses the flexible cover. In a normal state, e.g. when no failure event occurs, the flexible cover covers the recess such that footprint is advantageously not increased during normal operation.

In a failure state, e.g. when the failure event occurs, pressure in the cavity increases and leads to an unfolding of the flexible cover. Due to the increasing volume, i.e. an increase from the first volume to the second volume, the pressure in the cavity can be kept comparatively low by giving the explosion room to expand, in contrast to a rigid housing.

This advantageously prevents damage to other nearby power electronic components. Further, the flexible cover advantageously leads to a confinement of all the debris and the hot plasma within the cavity resulting from the explosion.

Advantageously, the use of the flexible cover results in an inexpensive design with comparatively low complexity. Furthermore, there are no additional losses. The flexible cover can be advantageously combined with other protection measures.

According to a further embodiment of the power electronic component, the flexible cover and the housing hermetically seal the at least one power semiconductor module and the heat sink. Exemplarily, substantially no gas and/or liquid is able to pass in the cavity. Advantageously, the elements inside the cavity are protected from the environment, in particular from moisture and dust.

According to a further embodiment of the power electronic component, the folded part and the cover part are formed in one piece. Exemplarily, the folded part and the cover part are formed of the same material. In particular, the folded part and the cover part are continuously formed, exemplarily without the need for joins.

The flexible cover comprises or consists, exemplarily, of a fabric. The fabric exemplarily comprises Kevlar and/or glass fibres. Advantageously, the flexible cover is made of a highly durable material which can withstand the explosion. Exemplarily, a tensile strength of the flexible cover is at least 1000 MPa or at least 3000 MPa. A critical thermal stability temperature of the flexible cover is, for example, at least 500°C or at least 1000°C.

According to a further embodiment of the power electronic component, the folded part comprises a series of fold sections. The fold sections, e.g. the parts of the folded part, lie one on top of the other. Exemplarily, each fold section has a main extension plane, wherein the main extension planes of the fold sections are stacked above one another. A stacking direction of the stacked fold sections is perpendicular or parallel to the main extension planes. Main surfaces of directly neighboring fold sections are, for example, at least regionally in direct contact with one another along the respective main surfaces of the respective fold sections.

The fold sections comprise inner fold sections and a first outer fold section and a second outer fold section. In particular, the inner fold sections are arranged between the first outer fold section and the second outer fold section. The first outer fold section and the second outer fold section are each characteristic of end fold sections of the fold sections. In particular, each inner fold section has two directly neighbouring fold sections, wherein the directly neighbouring fold sections are arranged above and below the corresponding main surface of the respective inner fold section.

According to a further embodiment of the power electronic component, directly neighbouring fold sections are connected by a crease line. Each inner fold section is connected to one of the directly neighbouring fold sections by a first crease line and connected to the other of the directly neighbouring fold sections by a second crease line. The first crease line and the second crease line are arranged at opposite sides of the respective inner fold section. Exemplarily, all crease lines are substantially parallel to one another. Substantially parallel means here and in the following that the crease lines can enclose an angle of at most 5° or at most 1°, due to production tolerances.

In particular, the fold sections are connected by the crease lines such that the folded part is characteristic of an accordion fold, also known as a zig-zag fold.

According to a further embodiment of the power electronic component, the fold sections are fixed together with a holding element, particularly comprising a thread, a clamp and/or a bracket.

Exemplarily, the clamp can be formed of a rivet. For example, the bracket is an adjustable bracket. Exemplarily, the holding element extends along the stacking direction. The holding element extends, for example, from the first outer fold section to the second outer fold section, in particular through the inner fold sections. The holding element, particularly the thread, is, for example, fixed to the first outer fold section and/or the second outer fold section, such that the folded part is folded.

Advantageously, the fold sections can be held together with the holding element, thus no footprint is increased for normal operation.

According to a further embodiment of the power electronic component, a critical strength of the holding element is smaller than a critical strength of the flexible cover. In particular, the critical strength of the holding element is smaller than a force of the explosion, such that the folded part is unfolded. The critical strength is, for example, characteristic of a force where the holding element breaks. Thus, the explosion advantageously leads to a breaking of the holding element but not the flexible cover such that the flexible cover can expand, i.e. unfold.

The critical strength of the holding element can refer to the holding element itself, e.g. a material of the holding element, and/or to a connection of the holding element to the first outer fold section and/or the second outer fold section.

Exemplarily, the first outer fold section is mechanically fixed to the housing, in particular by a connection element, and the second outer fold section is connected to the cover part. In particular, the critical strength of the holding element is smaller than the critical strength of the connection element and the connection to the cover part. Exemplarily, the holding element is the weakest part of the housing and the flexible cover.

According to a further embodiment, the fold sections are fixed together and/or fixed to the housing with a screw. Exemplarily, the connection element is the screw.

Exemplarily, the power electronic component comprises a holding element for fixing the fold sections together and the screw for fixing the folded part to the housing. Alternatively, the power electronic component comprises the screw for fixing the fold sections together and a further connection element for fixing the folded part to the housing.

According to a further embodiment, the critical strength of the screw is smaller than the critical strength of the flexible cover. If the power electronic component comprises the screw for fixing the fold sections together, the critical strength of the screw is smaller than the force of the explosion, leading to the unfolding of the folded part. The critical strength of the screw is, for example, characteristic of a minimum force where the screw breaks.

If the power electronic component comprises the screw for fixing the folded part to the housing, and in particular a connection of the screw to the housing, the critical strength of the screw is higher than the force of the explosion.

According to a further embodiment, the housing has at least one side surface, and the folded part is attached to the at least one side surface. In particular, the first outer fold section is attached in a mechanically fixed manner to the at least one side surface. Exemplarily, end regions of the side surface or the side surfaces facing the flexible cover delimit the recess.

According to a further embodiment, the housing has an outer surface, the recess is arranged in the outer surface, and the folded part is attached to the outer surface in a region surrounding the recess. Exemplarily, the outer surface is directly connected to the side surface. The outer surface extends, for example, obliquely to the side surface. Exemplarily, the outer surface extends perpendicular to the side surface.

Exemplarily, the region laterally surrounds the recess completely. For example, the folded part is attached in a mechanically fixed manner to the region.

According to a further embodiment, the at least one power semiconductor module is arranged on the heat sink.

According to a further embodiment, the at least one power semiconductor module is connected to a first busbar at a first side facing the flexible cover. The first busbar is, for example, arranged between the flexible cover and the power semiconductor module. The first busbar exemplarily provides an electrical interconnection of the power semiconductor module.

According to a further embodiment, the at least one power semiconductor module is connected to a second busbar at a second side facing away from the flexible cover. The power semiconductor module is, for example, arranged between the first busbar and the second busbar. The second busbar exemplarily provides a further electrical interconnection of the power semiconductor module.

According to a further embodiment, the second busbar is connected to at least one capacitor. In particular, the capacitor is connected to the second busbar at a second side facing away from the flexible cover. The second busbar exemplarily provides a further electrical interconnection of the power semiconductor module and the capacitor.

According to a further embodiment, the power electronic component comprises at least one power semiconductor bridge, the power semiconductor bridge comprises at least one power semiconductor module. Exemplarily, each power semiconductor module comprises several semiconductor chips arranged in a full bridge configuration and/or a half bridge configuration. Each power semiconductor module is, for example, connected to the first busbar and/or the second busbar.

According to a further embodiment, the power semiconductor module comprises at least one Insulated-Gate Bipolar Transistor, IGBT. In particular, the at least one power semiconductor chip of the power semiconductor module is an IGBT.

According to a further embodiment, the power semiconductor bridges are connected in parallel. In particular, the power semiconductor bridges are connected in parallel by the first busbar and the second busbar.

A further embodiment relates to a system, in particular comprising a power electronic component as described herein above. Therefore, the features as described in connection with the system are also applicable for the power electronic component and vice versa.

According to an embodiment, the system comprises at least two power electronic components. At least one of the two power electronic components is the power electronic component described herein above.

Exemplarily, the at least two power electronic components can be arranged next to one another, being spaced apart from one another in lateral directions. The flexible cover of the at least one of the two power electronic components faces, for example, the other power electronic component. Advantageously, if the power electronic component fails and the explosion happens, the flexible cover advantageously leads to a direct confinement of all debris and plasma resulting from the explosion, thus protecting the other power electronic component.

According to a further embodiment of the system, the power electronic components are stacked above one another along a stacking direction. Exemplarily, the stacking direction is parallel to the main extension plane of the cover part. For example, the side surfaces of directly neighboring power electronic components are stacked above one another.

According to a further embodiment of the system, none of the flexible covers of the power electronic components stacked above one another face the neighboring power electronic component. Thus, advantageously, if the power electronic component fails, the other power electronic component is protected from the debris of the explosion.

Exemplarily, the stacked power electronic components form a group of power electronic components. The system can comprise at least two groups of power electronic components, which are, for example, arranged next to one another, being spaced apart from one another in lateral directions.

For example, all power electronic components have the flexible cover as described herein above.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.

Figures 1 and 2 each shows a schematic view of a power electronic component according to an exemplary embodiment.

Figure 3 shows a schematic view of a system according to an exemplary embodiment.

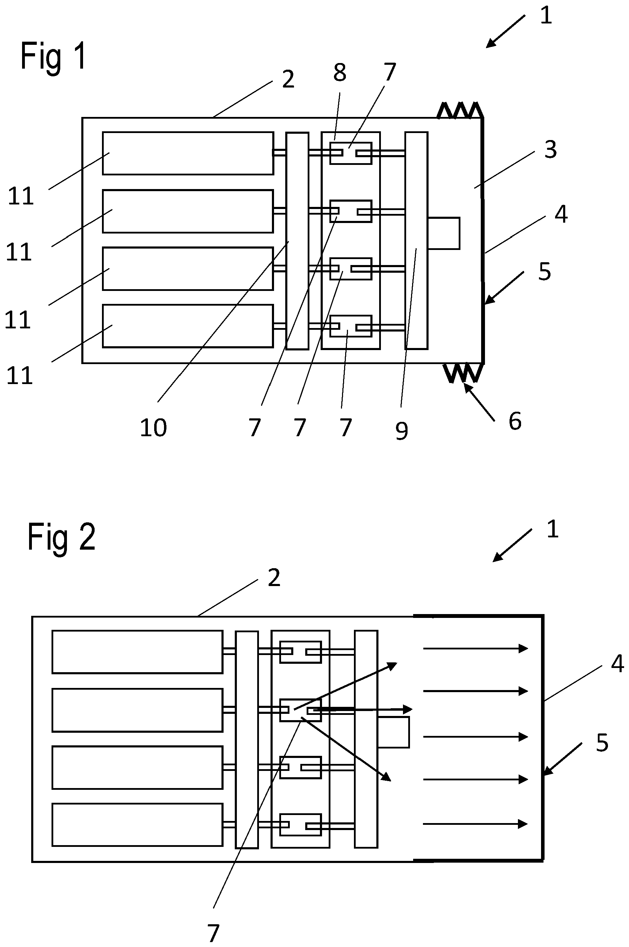

The power electronic component 1 according to the exemplary embodiment of Figure 1 comprises a housing 2. The housing 2 has side surfaces extending in a main extension plane, e.g. in lateral directions. The side surfaces comprise a first side surface and a second side surface. The first side surface and the second side surface are connected by a further outer surface, extending perpendicular to the main extension planes of the side surfaces, e.g. in vertical direction. The housing 2 has a recess 3 opposite to the further outer surface.

The housing 2 defines a cavity in which elements of the power electronic component 1 are arranged. The recess 3 provides a through hole to the cavity.

Furthermore, the power electronic component 1 comprises a flexible cover 4 covering the recess 3, wherein the flexible cover 4 has a folded part 6 for providing flexibility and a cover part 5 for covering the recess 3. The flexible cover 4 is configured to be expanded.

The folded part 6 is arranged on the first side surface of the housing 2. The folded part 6 comprises fold sections that are connected by crease lines. The fold sections are particularly stacked above one another such that the fold sections are characteristic of an accordion fold. The fold sections comprise a first outer fold section and a second outer fold section between which inner fold sections are arranged. The first outer fold section is fixed to the housing 2. The second outer fold section is fixed to the cover part 5. Particularly, the folded part 6 and the cover part 5 are formed in one piece.

The flexible cover 4, particularly the cover part 5, completely covers the recess 3. The housing 2 and the cover delimit the cavity. Particularly, the housing 2 and the cover surround at least some of all elements of the power electronic component 1 three-dimensionally, i.e. in lateral directions and vertical direction.

The power electronic component 1 comprises power semiconductor modules 7, in this embodiment four power semiconductor modules 7. The power semiconductor modules 7 are arranged on a heat sink 8, particularly a common heat sink 8 for the power semiconductor modules 7.

Additionally, the power electronic component 1 comprises capacitors 11, in this embodiment four capacitors 11, a first busbar 9 and a second busbar 10. The first busbar 9 is arranged at a first side facing the flexible cover 4. The capacitor 11 and the second busbar 10 are arranged at a second side facing away from the flexible cover 4. Each power semiconductor module 7 comprises power semiconductor chips arranged in a bridge topology. Thus, each power semiconductor module 7 can be a power semiconductor bridge. The power semiconductor modules 7 are connected in parallel, in particular by the first busbar 9 and the second busbar 10.

At least some or all of the power semiconductor chips of one power semiconductor module 7 are exemplarily formed of an IGBT.

The first busbar 9 is arranged between the power semiconductor modules 7 and the flexible cover 4. The second busbar 10 is arranged between the power semiconductor modules 7 and the capacitors 11. Particularly, the capacitors 11, the first busbar 9, the second busbar 10 and the heat sink 8 are each connected to the housing 2 in a mechanically fixed manner.

In Figure 1, the power electronic component 1 is in a normal state, e.g. when no failure event happens, such that the flexible cover 4 covers the recess 3.

In Figure 2, the power electronic component 1 is in failure state, e.g. when a failure event occurs. When the failure event occurs, pressure in the cavity increases and leads to an unfolding of the flexible cover 4. Due to the increasing volume, the pressure in the cavity can be kept comparatively low by giving the explosion room to expand, in contrast to a rigid housing 2. Advantageously, the hot plasma as well as the debris, indicated as arrows, of the explosion are constrained by the housing 2 and the flexible cover 4.

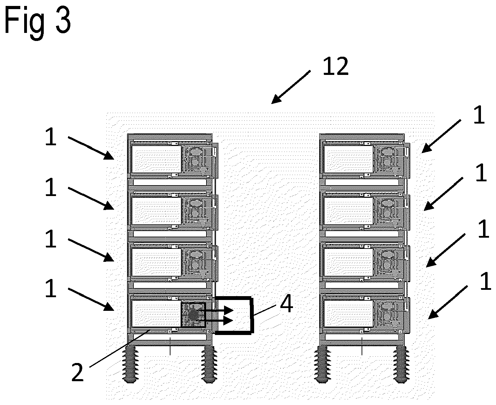

The system 12 according to the exemplary embodiment of Figure 3 comprises two groups of power electronic components 1 arranged laterally next to one another, and being spaced apart from one another in lateral directions. Each group comprises power electronic components 1 stacked above one another in vertical direction.

Furthermore, at least some or all of the power electronic components 1 of at least some or all groups are provided with the flexible cover 4.

In the failure state of one of the power electronic components 1, the explosion comprising the hot plasma as well as the debris, indicated as arrows, is confined accordingly, such that the other power electronic converters are protected.

The exemplary embodiments, in particular features of the exemplary embodiments, of the Figures can be combined with one another.

### Reference Signs

- 1: power electronic component
- 2: housing
- 3: recess
- 4: flexible cover
- 5: cover part
- 6: folded part
- 7: power semiconductor module
- 8: heat sink
- 9: first busbar
- 10: second busbar
- 11: capacitor
- 12: system

## Claims

1. Power electronic component (1), comprising
- a housing (2) having a recess (3),
- a flexible cover (4) covering the recess (3),
- at least one power semiconductor module (7),
- a heat sink (8), wherein
- the at least one power semiconductor module (7) and the heat sink (8) are arranged inside the housing (2), and
- the flexible cover (4) has a folded part (6) for providing flexibility and a cover part (5) for covering the recess (3), the flexible cover (4) being configured to be expanded.

2. Power electronic component (1) according to claim 1, wherein
- the flexible cover (4) and the housing (2) hermetically seal the at least one power semiconductor module (7) and the heat sink (8).

3. Power electronic component (1) according to claim 1 or 2, wherein
- the folded part (6) and the cover part (5) are formed in one piece.

4. Power electronic component (1) according to one of claims 1 to 3, wherein
- the folded part (6) comprises a series of fold sections, and
- directly neighbouring fold sections are connected by a crease line.

5. Power electronic component (1) according to claim 4, wherein
- the fold sections are fixed together with a holding element, particularly comprising a thread, a clamp and/or a bracket, and
- the critical strength of the holding element is smaller than the critical strength of the flexible cover (4).

6. Power electronic component (1) according to claim 4 or 5, wherein
- the fold sections are fixed together and/or fixed to the housing (2) with a screw, and/or
- the critical strength of the screw is smaller than the critical strength of the flexible cover (4).

7. Power electronic component (1) according to one of claims 1 to 6, wherein
- the housing (2) has at least one side surface, and
- the folded part (6) is attached to the at least one side surface.

8. Power electronic component (1) according to one of claims 1 to 6, wherein
- the housing (2) has an outer surface,
- the recess (3) is arranged in the outer surface, and
- the folded part (6) is attached to the outer surface in a region surrounding the recess (3).

9. Power electronic component (1) according to one of claims 1 to 8, wherein
- the at least one power semiconductor module (7) is arranged on the heat sink (8).

10. Power electronic component (1) according to one of claims 1 to 9, wherein
- the at least one power semiconductor module (7) is connected to a first busbar (9) at a first side facing the flexible cover (4).

11. Power electronic component (1) according to one of claims 1 to 10, wherein
- the at least one power semiconductor module (7) is connected to a second busbar (10) at a second side facing away from the flexible cover (4), and
- the second busbar (10) is connected to at least one capacitor (11).

12. Power electronic component (1) according to one of claims 1 to 11, wherein
- the power electronic component (1) comprises at least one power semiconductor bridge,
- the power semiconductor bridge comprises at least one power semiconductor module (7), and
- the power semiconductor module (7) comprises at least one Insulated-Gate Bipolar Transistor, IGBT.

13. Power electronic component (1) according to claim 12, wherein
- the power semiconductor bridges are connected in parallel.

14. System (12), comprising
- at least two power electronic components (1), with at least one of the power electronic components (1) being the power electronic component (1) according to one of claims 1 to 13.

15. System (12) according to claim 14, wherein
- the power electronic components (1) are stacked above one another along a stacking direction, and
- none of the flexible covers (4) of the power electronic components (1) stacked above one another faces the neighboring power electronic component (1).
